# EUROPÄISCHE PATENTANMELDUNG

(11) **EP 4 036 733 A1**
(43) Veröffentlichungstag der Anmeldung: **03.08.2022**
(21) Anmeldenummer: 21154309.5
(22) Anmeldetag: 29.01.2021
(51) Int. Cl.: G06F 11/10, G06F 11/07, G01R 31/08, H02H 1/00, H02H 7/26, H02J 3/00, H02J 13/00

(54) **ELEKTRISCHES BETRIEBSMITTEL UND VERFAHREN ZUM ERKENNEN VON STÖRUNGEN**

(71) Anmelder: Siemens Aktiengesellschaft, 80333 München (DE)
(72) Erfinder: Mieske, Frank, 13053 Berlin (DE); Persdorf, Dennis, 13503 Berlin (DE)

(57) **Zusammenfassung**

Gegenstand der vorliegenden Erfindung ist ein elektrisches Betriebsmittel (1), aufweisend
eine Messeinrichtung (8) für eine elektrische Messgröße (U), und
eine Vorverarbeitungseinrichtung (13) für digitale Messwerte (12), wobei die Vorverarbeitungseinrichtung (13) einen integrierten Schaltkreis (14) und einen elektronischen Speicherbaustein (15) zur Konfiguration einer logischen Schaltung aufweist, und
eine Prozessoreinrichtung (22), die ausgebildet ist, die vorverarbeiteten Messdaten (12) auszuwerten und basierend auf der Auswertung Datentelegramme (29) an andere elektrische Betriebsmittel (4) zu senden,
dadurch gekennzeichnet, dass
die Vorverarbeitungseinrichtung (13) ausgebildet ist, für einen digitalen Messwert (12) jeweils einen Prüfwert (24) zu berechnen, und dass
die Prozessoreinrichtung (22) ausgebildet ist, anhand des Messwerts (12) und des jeweiligen Prüfwerts (24) des Messwerts (12) eine Störung zu erkennen, und im Falle einer Störung die Auswertung und/oder das Senden von Datentelegrammen (29) zu unterdrücken.

Ferner ist Gegenstand der vorliegenden Erfindung ein Verfahren zum Erkennen von Störungen.

## Beschreibung

Die Erfindung betrifft ein Elektrisches Betriebsmittel nach dem Oberbegriff des Anspruchs 1 und ein Verfahren zum Erkennen von Störungen nach dem Oberbegriff des Anspruchs 9.

Ein sog. "Single Event Upset" (SEU) ist ein "Soft Error", d.h. ein "weicher" Fehler), der in Halbleiterbauelementen beim Durchgang hochenergetischer ionisierender Strahlung (z.B. Schwerionen, Protonen, Gamma-Strahlung, kosmische Strahlung) hervorgerufen werden kann. Er äußert sich beispielsweise als Bitflip (Änderung des Zustandes eines Bits) in Speicherbausteinen oder Registern, was zu einer Fehlfunktion des betroffenen Bauteils führen kann. Die Klassifizierung als "Soft Error" rührt daher, dass ein SEU keinen dauerhaften Schaden am betroffenen Bauteil bewirkt. Der Effekt wird beispielsweise auf Wikipedia beschrieben (permanenter Link: https://de.wikipedia.org/w/index.php?title=Single_Event_Upset &oldid=163234538) .

Ein "Field Programmable Gate Array" (FPGA) oder programmierbares Logikgatter ist ein integrierter Schaltkreis der Digitaltechnik, in welchen eine logische Schaltung geladen werden kann. Ein solcher FPGA ist beispielsweise von Wikipedia bekannt (permanenter Link https://de.wikipedia.org/w/index.php?title=Field_Programmable _Gate_Array&oldid=206575960)

In modernen multifunktionalen Schutz- bzw. Steuergeräten ist der Einsatz von FPGAs und deren frei programmierbare Logik unumgänglich. Häufig werden sog. "static random-access memory" (SRAM) basierte FPGAs eingesetzt, die zwar kostengünstig sind, aber dem SEU-Effekt unterliegen und damit anfällig für Fehlfunktionen. Ein solcher FPGA ist beispielsweise von Wikipedia bekannt (permanenter Link https://de.wikipedia.org/w/index.php?title=Static_random-access_memory&oldid=204940730).

Insbesondere sind Analogmesswerte für Spannungen und Ströme besonders kritisch zu betrachten, da nach der Digitalisierung der analogen Messgrößen schon ein einzelner verfälschter digitaler Messwert zu einer falschen Entscheidung im Gerät führen kann. In der Schutztechnik könnte es z.B. zu einer Fehlauslösung des Schutzgeräts und damit zu einer Abschaltung eines Netzabschnitts kommen. Es könnte ein hoher finanzieller Schaden entstehen.

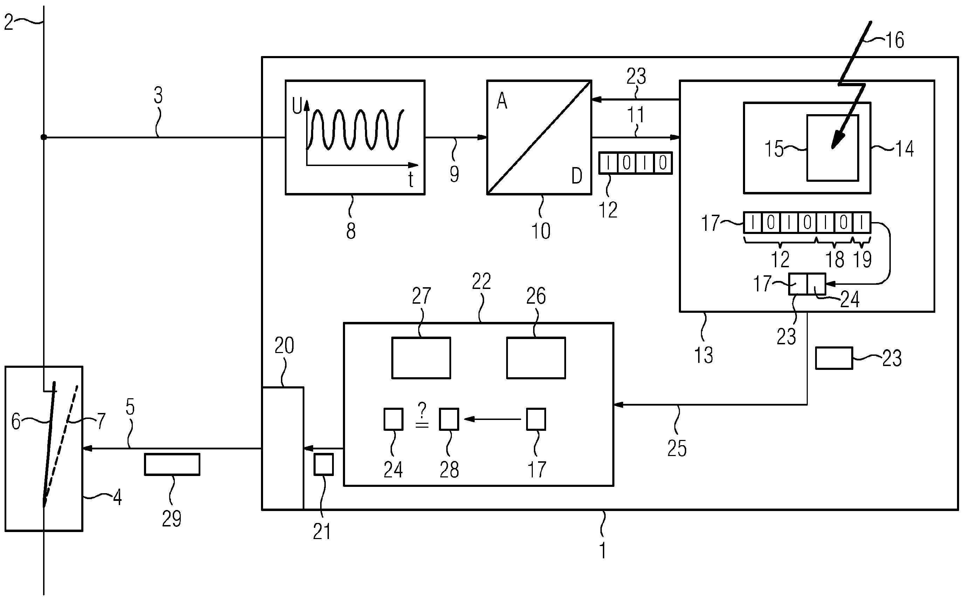

Das Problem von SEUs bei Schutzgeräten wird in der Veröffentlichung "Single Event Upsets in SEL Relays", Schweitzer Engineering Laboratories, Inc., 2018, thematisiert. Es wird z.B. ein Bitflip von 0 zu 1 aufgrund der Einwirkung von Alpha-Strahlung erläutert. Auf Seite 9 fortfolgend wird unter der Überschrift "Impact on Protective Relays" auf die möglichen schwerwiegenden Folgen eines Fehlers in einem Schutzgerät abgestellt. Als Reaktion auf Fehler in Schutzgeräten wird ein kontrollierter Neustart des Geräts vorgeschlagen. Ferner wird die Möglichkeit von redundanten Systemen in Figur 8 gezeigt. Z.B. werden drei Geräte bzw. deren Messwertverarbeitungs- und Prozessoreinrichtungen parallel betrieben. Eine Auswertung wird nur dann als korrekt betrachtet, wenn mindestens zwei Geräte das gleiche Ergebnis liefern (Entscheidung "2 aus 3"). Diese Bauweise ist vergleichsweise aufwendig und teuer; es ist ferner ein erhöhter Platzbedarf gegeben.

Ferner ist es bekannt, bei FPGAs eine regelmäßige automatisierte Erkennung von Bitfehlern durchzuführen. Dabei wird z.B. für die gesamte Konfiguration einer logischen Schaltung des FPGAs eine Checksumme gebildet, d.h. im einfachsten Fall werden alle Bits addiert. Aus der Veröffentlichung "LatticeXP2 Soft Error Detection (SED) Usage Guide", Lattice Semiconductor, 2012, ist es bekannt, die Konfiguration eines FPGA mittels Cyclischer Redundanzprüfung (CRC) zu überprüfen.

Allerdings hat es sich im Betrieb z.B. eines Schutzgeräts mit einem solchen FPGA gezeigt, dass diese Erkennung zwischen einigen Millisekunden bis zu einer Sekunde dauert. In diesem Zeitraum kann es zur Fehlfunktion kommen, die z.B. zu fehlerhaften Schalthandlungen und damit verbundenen Schäden führt.

Des Weiteren werden teilweise flashbasierte FPGAs eingesetzt, was von Vorteil ist, da Flash-Speicher für die Konfiguration im wesentlich unempfindlicher gegenüber SEUs sind. Nachteilig ist, dass flashbasierte FPGAs im Vergleich zu SRAM basierten FPGAs wesentlich teurer sind.

An die Erfindung stellt sich ausgehend von bekannten elektrischen Betriebsmitteln die Aufgabe, ein vergleichsweise kostengünstig herstellbares Betriebsmittel anzugeben, mit dem Fehler der Steuerung eines Energienetzes aufgrund der Einwirkung von ionisierender Strahlung auf Halbleiterbausteine vergleichsweise sicher vermieden werden.

Die Erfindung löst diese Aufgabe durch ein elektrisches Betriebsmittel nach Anspruch 1.

Ein elektrisches Betriebsmittel kann beispielsweise ein Schutzgerät aufweisen, das in einem elektrischen Energieübertragungs- oder Energieverteilungsnetz angeordnet ist und beispielsweise einen Distanzschutz und/oder einen Differentialschutz und/oder einen Überspannungsschutz gewährleistet. Das Schutzgerät kann entsprechend Schutzbefehle an Leistungsschalter im Energienetz senden. Ein Energieübertragungs- oder Energieverteilungsnetz kann der Mittelspannungsebene (über 1 kV bis 52 kV) oder der Hochspannungsebene (über 52 kV) zugeordnet sein.

Die Messeinrichtung misst beispielsweise Strom- und/oder Spannungswerte als elektrische Messgrößen. Es können z.B. beide Werte erfasst und analog weiter übertragen werden, beispielsweise an einen Analog-Digital-Wandler.

Die Vorverarbeitungseinrichtung für digitale Messwerte ist z.B. ausgebildet, um digitale Messwerte abzufragen, beispielsweise von einem Analog-Digital-Wandler. Die Abtastrate kann beispielsweise zw. 1 kHz und 100 kHz liegen, bevorzugt sind 5 kHz bis 15 kHz, noch mehr bevorzugt 8 kHz. Der Speicherbaustein mit der Konfiguration ist beispielsweise anfällig für Bitflips infolge einer Einwirkung von ionisierender Strahlung, was beispielsweise zur fehlerhaften Erkennung eines viel zu hohen Strom- oder Spannungswerts führen könnte. Entsprechend würde beispielsweise in der Prozessoreinrichtung ein Schwellenwert für die Auslösung eines Schutzbefehls zur Netzabschaltung fälschlicherweise ausgelöst werden, was erhebliche Kosten in Millionenhöhe für den Netzbetreiber nach sich ziehen kann.

Die Prozessoreinrichtung weist beispielsweise einen Prozessor auf sowie elektronische Datenspeicher zur Zwischenablage und/oder dauerhaften Speicherung von Daten. Die Datentelegramme können beispielsweise Schutzbefehle enthalten. Bei der Auswertung kann es sich beispielsweise in einem einfachen Fall um eine Überprüfung handeln, ob vorgegebene Grenzwerte für Strom- und Spannung überschritten werden. Ein Datentelegramm kann beispielsweise eine Abfolge von Bits sein, die unterschiedliche Daten kodieren. Es kann z.B. ein Schutzbefehl enthalten sein. Das Senden der Datentelegramme kann z.B. mittels einer Datenkommunikationseinrichtung erfolgen. Dabei kann eine Übertragung über eine Stromleitung, d.h. eine sog. "Powerline-Communication", eingesetzt werden. Alternativ kann auch eine Übertragung per Datenkabel (z.B. Ethernet über Kupferleitung oder Lichtwellenleiter) oder per Funk (long range radion, 2G, 3G, 4G, 5G) erfolgen. Es kann beispielsweise auch eine Übermittelung unter Zuhilfenahme von TCP/IP über das Internet erfolgen.

Als andere elektrische Betriebsmittel können z.B. Schalter im Energienetz verwendet werden.

Der Prüfwert wird beispielsweise direkt aus den Bits des digitalen Messwerts gebildet und ist reproduzierbar, d.h. er erlaubt auch später eine eindeutige Aussage, ob der Prüfwert aus der dann vorliegenden Bitfolge berechnet wurde. Ist dies der Fall, so kann angenommen werden, dass der digitale Messwert korrekt übermittelt und verarbeitet wurde. Ist dies nicht der Fall, so kann davon ausgegangen werden, dass ein Fehler wie beispielsweise ein Bitflip erfolgt ist.

Die Vorverarbeitungseinrichtung kann beispielsweise den zugeordneten Prüfwert zusammen mit dem zugrundeliegenden digitalen Messwert, also einer Bitfolge, an die Prozessoreinrichtung weitergeben. Dort kann anhand der Bitfolge des digitalen Messwerts erneut ein Prüfwert berechnet und mit dem übermittelten Prüfwert verglichen werden. Beispielswiese kann hierfür eine Vergleichseinrichtung vorgesehen sein, die in Hardware oder Software ausgebildet ist. Die Vergleichseinrichtung ist bevorzugt der Prozessoreinrichtung zugeordnet.

Stimmen beide Prüfwerte nicht überein, so ist von einer Störung auszugehen, d.h. von einer Veränderung des zugrundeliegenden digitalen Messwerts. Diesen darf entsprechend nicht vertraut werden und er muss für weitere Auswertungsschritte unberücksichtigt bleiben. Es wird kein Datentelegramm mit z.B. einem Schutzbefehl ausgesendet, weil das Senden blockiert wird oder weil erst gar keine vorgelagerte Auswertung des fehlerbehafteten digitalen Messwerts erfolgt. Dadurch wird eine Überfunktion des Gerätes
vermieden.

Der beschriebene Ansatz ermöglicht jedoch keine 100% Erkennungssicherheit für Bitflips, da beispielsweise ein Bitflip nicht erkannt wird, der nach Erzeugung der digitalen Messwerte und vor der Berechnung des Prüfwerte eintritt. Die Wahrscheinlichkeit für den Eintritt dieses Fehlers ist allerdings verschwindend gering, weil die Eintrittswahrscheinlicht eines Fehlers bei Bestrahlung proportional zu Querschnittsfläche ist. Da der gesamte Halbleiteraufbau wesentlich größer ist als der für die Prüfwertberechnung benötigte Bereich der Vorverarbeitungseinrichtung, dürften nur wenige Prozent aller Bitflips vor der Prüfwertberechnung auftreten.

Es ist ein wesentlicher Vorteil der vorliegenden Lösung, dass keine ggf. schon installierte Hardware geändert werden muss. Eine Integration kann vielmehr durch ein Update von FPGA-Firmware und Software in bereits vorhandene bzw. schon installierte Geräte oder zukünftige Geräte erfolgen. Es entsteht dadurch ein enormes Kosteneinsparungspotenzial, einerseits für Hersteller von elektrischen Betriebsmitteln, die ihre Geräte durch ein einfaches update sicherer und zuverlässiger machen können, und andererseits für Energienetzbetreiber, die Fehlhandlungen und Folgekosten weiter vermindern können, ohne zuvor neue Hardware installieren zu müssen. Auch bisherige Lösungsansätze mit redundanten Signalverarbeitungsketten, die vergleichsweise sicher, aber teuer sind, entfallen.

In einer bevorzugten Ausführungsform des erfindungsgemäßen elektrischen Betriebsmittels wird für den Prüfwert eine Checksumme der Bits des digitalen Messwerts gebildet. In einem einfachen Fall wird beispielsweise für die Bitfolge 10010 die Checksumme 2 durch Addition der einzelnen Bits der Bitfolge berechnet. Alternativ kann beispielsweise auch eine Cyclische Redundanzprüfung vorgenommen werden, bei der eine Polynomdivision für die Bestimmung des Prüfwerte eingesetzt wird.

In einer weiteren bevorzugten Ausführungsform des erfindungsgemäßen elektrischen Betriebsmittels wird für den Prüfwert zusätzlich eine Wichtung der Bits des digitalen Messwerts vorgenommen und/oder eine Kanalinformation berücksichtigt. Eine Wichtung der Bits ermöglicht es, Bitvertauschungen zu erkennen. Wird beispielsweise das Erste Bit der Bitfolge 10010 am stärksten (mit dem Faktor 5) gewichtet und das letzte Bit am schwächsten (mit dem Faktor 1), so ergibt sich die Prüfsumme 5+0+0+2+0 = 7. Liegt ein Bitflip der Art 10100 vor, so ergibt sich statt dessen ein Prüfwert von 5+0+3+0+0 = 8. Der Fehler kann sicher erkannt werden. Elektrische Betriebsmittel, die mehrere Phasen und/oder mehrere Messeingänge aufweisen, arbeiten häufig mit einer Reihe von Kanälen. Entsprechend ist dem digitalen Messwert auch eine Bitfolge zugeordnet, die für den Kanal kodiert. Tritt hier ein Bitflip auf, so führt auch dies zu einer Störung, weil beispielsweise in der Prozessoreinrichtung ein Spannungsmesswert einer ersten Messeinrichtung für einen Strommesswert einer zweiten Messeinrichtung gehalten wird. Deshalb ist es sinnvoll, auch die richtige Kanalzuordnung mit dem Prüfwert zu überprüfen. Diese Checksummenbildung ist vom Algorithmus her so gebildet, dass sie in Echtzeit und ressourcenarm implementiert werden kann.

In einer weiteren bevorzugten Ausführungsform des erfindungsgemäßen elektrischen Betriebsmittels ist die Prozessoreinrichtung ausgebildet, im Falle einer Störung die Auswertung und/oder das Senden von Datentelegrammen mindestens solange zu unterbinden, bis anhand eines weiteren Messwerts und des jeweiligen Prüfwerts des weiteren Messwerts keine Störung mehr erkannt wird. Wird beispielsweise ein analoges Messsignal der Messeinrichtung mit 8 kHz abgetastet, so werden pro Sekunde 8000 digitale Messwerte mitsamt zugeordnetem Prüfwert erstellt und übermittelt. In diesem Beispiel läge ein neuer digitaler Messwert mitsamt zugeordnetem Prüfwert nach 1/8000 Sekunde vor. Eine Auslösung eines Datentelegramms würde unterbunden, bis auch der neue digitale Messwert überprüft und für korrekt erkannt wäre. Zeigt dieser neue Messwert beispielsweise keine Grenzwertverletzung, so wird kein Datentelegramm gesendet. Bestätigt der neue Messwert eine Grenzwertverletzung, so wird ein Datentelegramm abgesandt.

In einer weiteren bevorzugten Ausführungsform des erfindungsgemäßen elektrischen Betriebsmittels ist die Prozessoreinrichtung ausgebildet, im Falle keiner Störung die Auswertung und/oder das Senden von Datentelegrammen freizugeben.

In einer weiteren bevorzugten Ausführungsform des erfindungsgemäßen elektrischen Betriebsmittels weisen der integrierte Schaltkreis ein field-programmable gate-array und der elektronische Speicherbaustein ein static random-access memory auf. Dies ist ein Vorteil, weil insbesondere static randomacess memory (SRAM) Halbleiterbausteine empfindlich für Bitflips infolge ionisierender Strahlung sind.

In einer weiteren bevorzugten Ausführungsform des erfindungsgemäßen elektrischen Betriebsmittels ist ein Analog-Digital-Wandler ausgebildet, eine analoge elektrische Messgröße mit einer vorgegebenen Abtastrate in einen digitalen Messwert umzuwandeln. Dies ist ein Vorteil, weil auf diese Weise analoge Messwerte einfach in digitale Messwerte mit vorgegebener Abtastrate umgewandelt werden können.

In einer weiteren bevorzugten Ausführungsform des erfindungsgemäßen elektrischen Betriebsmittels weisen das Betriebsmittel ein Schutzgerät und die Datentelegramme Schutzbefehle auf, und das Schutzgerät weist eine Datenkommunikationseinrichtung zum Senden der Datentelegramme an Schalter als andere Betriebsmittel in einem Energienetz aufweist.

An die Erfindung stellt sich ferner die Aufgabe, ein Verfahren zum Erkennen von Störungen in einem elektrischen Betriebsmittel anzugeben, mit dem Fehler der Steuerung eines Energienetzes aufgrund der Einwirkung von ionisierender Strahlung auf Halbleiterbausteine vermieden werden.

Die Erfindung löst diese Aufgabe durch ein Verfahren nach Anspruch 9. Bevorzugte Ausführungsformen ergeben sich aus den Unteransprüchen 10 bis 15. Es ergeben sich dabei für das erfindungsgemäße Verfahren und seine Ausführungsformen sinngemäß die gleichen Vorteile wie eingangs für das erfindungsgemäße elektrische Betriebsmittel erläutert.

Zur besseren Erläuterung der Erfindung zeigt die Figur ein Ausführungsbeispiel eines erfindungsgemäßen elektrischen Betriebsmittels in schematischer Darstellung.

Eine elektrische Leitung 2 eines Energieübertragungsnetzes der Hochspannungsebene ist (ggf. über einen nicht dargestellten Messwandler) mittels der Leitung 3 mit einem elektrisches Betriebsmittel 1 verbunden, das als Schutzgerät ausgebildet ist. Im Schutzgerät 1 wird eine Messwertverarbeitungskette dargestellt.

Eine Messeinrichtung 8 für eine elektrische Messgröße ist ausgebildet, eine Spannung U in ihrem zeitlichen Verlauf zu bestimmen. Ausgegeben werden über eine analoge Verbindung 9 analoge Messwerte, in diesem Fall ein Momentan-Spannungswert. Dieser Momentan-Spannungswert wird in einem Analog-Digital-Wandler 10 mit einer vorgegebenen Abtastrate von z.B. 8 kHz in eine Bitfolge (z.B. "1010") umgewandelt, die einen digitalen Messwert 12 angibt.

Dieser digitale Messwert 12 wird beispielsweise von einer eine Vorverarbeitungseinrichtung 13 für digitale Messwerte 12 abgefragt. Dabei weist die Vorverarbeitungseinrichtung einen integrierten Schaltkreis 14 und einen elektronischen Speicherbaustein 15 zur Konfiguration einer logischen Schaltung auf, wobei der integrierte Schaltkreis ein field-programmable gate-array (FPGA) und der elektronische Speicherbaustein ein static random-access memory (SRAM) aufweisen.

Der FPGA versieht jeden digitalen Messwert 12 sofort bei Eingang mit einem Prüfwert 24, beispielsweise einer Checksumme der Bits des digitalen Messwerts 12. Ferner kann zusätzlich zum Prüfwert 24 eine Kanalinformation 19 berücksichtigt werden. Auch ein Zeitstempel 18 kann zusätzlich berücksichtigt werden. Es ergibt sich somit eine Bitfolge 17, für die - ggf. zusätzlich mit einer Wichtung der Bits des digitalen Messwerts - der Prüfwert 24 berechnet wird. Wirkt nun hochenergetische Strahlung, beispielsweise ionisierende Strahlung wie z.B. Gamma-Strahlung 16 auf den elektronischen Speicherbaustein 15 ein, so kann sich ein sog. SEU ergeben. Dies kann zu einem Bitflip innerhalb der Bitfolge 17 führen, der folglich zu einem veränderten Prüfwert 24 führen würde. D.h., dass ein SEU dazu führt, dass in der Bitfolge 24 der Prüfwert 24 nicht mehr zur nun veränderten Bitfolge 17 mit dem digitalen Messwert passt.

Der Prüfwert 24 wird nun zusammen mit der Bitfolge 17, die zumindest den digitalen Messwert 12 enthält, als Bitfolge 23 durch die weitere Messwertkette mitgeführt.

Über die Datenleitung 25 wird die Bitfolge 23 einer Prozessoreinrichtung 22 mit einer "central processing unit" (CPU) 26 und einen Datenspeicher 27 zur Verfügung gestellt.

Die Prozessoreinrichtung 22 ist ausgebildet, die vorverarbeiteten Messdaten, d.h. die Bitfolge 17 aus der Bitfolge 23, auszuwerten. Sie kann aus dem Messwert 12 und den weiteren Informationen 18,19 in der Bitfolge 17 sowie des jeweiligen Prüfwerts 24 eine Störung erkennen, und im Falle einer Störung die Auswertung und/oder das Senden von Datentelegrammen an andere elektrische Betriebsmittel 4 unterdrücken. Dieses Erkennen einer Störung erfolgt, indem ein zweiter Prüfwert 28 aus der Bitfolge 17 berechnet und mit dem Prüfwert 24 verglichen wird. Stimmen beide Prüfwert überein, so liegt die Bitfolge 17 unverändert vor - es hat keinen SEU gegeben. Stimmen beide Prüfwerte nicht überein, so wird ein Fehler wie z.B. ein Bitflip eines oder mehrerer Bits vermutet.

Liegt keine Störung vor, so kann die Prozessoreinrichtung 22 den digitalen Messwert 12 usw. auswerten und bei Verletzung vorgegebener Grenzwerte beispielsweise eine Schutzfunktion für das elektrische Energienetz ausführen. In diesem Fall übergibt die Prozessoreinrichtung 22 einen Schutzbefehl 21 an eine Datenkommunikationseinrichtung 20, die ausgebildet ist, den Schutzbefehl 21 als ein Datentelegramm 29 über eine Datenkommunikationsverbindung 5 an einen Schalter 4 zu übermitteln.

Beispielsweise wird bei Empfang des Datentelegramms 29 in einer Steuereinrichtung (nicht dargestellt) für den Schalter 4 dieser ausgelöst, so dass der Schalter 4 von einem geschlossenem Zustand 6 in einen offenen Zustand 7 wechselt.

## Patentansprüche

1. Elektrisches Betriebsmittel (1), aufweisend
eine Messeinrichtung (8) für eine elektrische Messgröße (U), und
eine Vorverarbeitungseinrichtung (13) für digitale Messwerte (12), wobei die Vorverarbeitungseinrichtung (13) einen integrierten Schaltkreis (14) und einen elektronischen Speicherbaustein (15) zur Konfiguration einer logischen Schaltung aufweist, und
eine Prozessoreinrichtung (22), die ausgebildet ist, die vorverarbeiteten Messdaten (12) auszuwerten und basierend auf der Auswertung Datentelegramme (29) an andere elektrische Betriebsmittel (4) zu senden,
**dadurch gekennzeichnet, dass**
die Vorverarbeitungseinrichtung (13) ausgebildet ist, für einen digitalen Messwert (12) jeweils einen Prüfwert (24) zu berechnen, und dass
die Prozessoreinrichtung (22) ausgebildet ist, anhand des Messwerts (12) und des jeweiligen Prüfwerts (24) des Messwerts (12) eine Störung zu erkennen, und im Falle einer Störung die Auswertung und/oder das Senden von Datentelegrammen (29) zu unterdrücken.

2. Elektrisches Betriebsmittel (1) nach Anspruch 1, **dadurch gekennzeichnet, dass** für den Prüfwert (29) eine Checksumme der Bits des digitalen Messwerts (12) gebildet wird.

3. Elektrisches Betriebsmittel (1) nach Anspruch 1 oder 2, **dadurch gekennzeichnet, dass** für den Prüfwert (24) zusätzlich eine Wichtung der Bits des digitalen Messwerts (12) vorgenommen wird und/oder eine Kanalinformation (19) berücksichtigt wird.

4. Elektrisches Betriebsmittel (1) nach einem der vorhergehenden Ansprüche, **dadurch gekennzeichnet, dass** die Prozessoreinrichtung (22) ausgebildet ist, im Falle einer Störung die Auswertung und/oder das Senden von Datentelegrammen (29) mindestens solange zu unterbinden, bis anhand eines weiteren Messwerts und des jeweiligen Prüfwerts des weiteren Messwerts keine Störung mehr erkannt wird.

5. Elektrisches Betriebsmittel (1) nach einem der vorhergehenden Ansprüche, **dadurch gekennzeichnet, dass** die Prozessoreinrichtung (22) ausgebildet ist, im Falle keiner Störung die Auswertung und/oder das Senden von Datentelegrammen (29) freizugeben.

6. Elektrisches Betriebsmittel (1) nach einem der vorhergehenden Ansprüche, **dadurch gekennzeichnet, dass** der integrierte Schaltkreis (14) ein field-programmable gate-array und der elektronische Speicherbaustein (15) ein static random-access memory aufweisen.

7. Elektrisches Betriebsmittel (1) nach einem der vorhergehenden Ansprüche, **dadurch gekennzeichnet, dass** ein Analog-Digital-Wandler (10) ausgebildet ist, eine analoge elektrische Messgröße (U) mit einer vorgegebenen Abtastrate in einen digitalen Messwert (12) umzuwandeln.

8. Elektrisches Betriebsmittel (1) nach einem der vorhergehenden Ansprüche, **dadurch gekennzeichnet, dass** das Betriebsmittel (1) ein Schutzgerät aufweist und dass die Datentelegramme (29) Schutzbefehle (21) aufweisen, und dass das Schutzgerät eine Datenkommunikationseinrichtung (20) zum Senden der Datentelegramme (29) an Schalter (4) als andere Betriebsmittel in einem Energienetz (2) aufweist.

9. Verfahren zum Erkennen von Störungen in einem elektrischen Betriebsmittel (1), aufweisend die Schritte:
Messen einer elektrische Messgröße (U) mittels einer Messeinrichtung (8), und
Vorverarbeiten von digitalen Messwerten (12) mittels einer Vorverarbeitungseinrichtung (12), wobei für die Vorverarbeitungseinrichtung (12) ein integrierter Schaltkreis (14) und ein elektronischer Speicherbaustein (15) zur Konfiguration einer logischen Schaltung verwendet werden, und
Auswerten der vorverarbeiteten Messdaten mittels einer Prozessoreinrichtung (22), und
Senden von auf der Auswertung basierenden Datentelegrammen (29) an andere elektrische Betriebsmittel (4), **gekennzeichnet durch** die Schritte:
Berechnen jeweils eines Prüfwerts (24) für einen digitalen Messwert (12) mittels der Vorverarbeitungseinrichtung (13), und
Erkennen einer Störung anhand des Messwerts (12) und des jeweiligen Prüfwerts (24) des Messwerts (12) mittels der Prozessoreinrichtung (22),
Unterdrücken der Auswertung und/oder des Sendens von Datentelegrammen (29) im Falle einer Störung.

10. Verfahren nach Anspruch 9, **dadurch gekennzeichnet, dass** für den Prüfwert (24) eine Checksumme der Bits des digitalen Messwerts (12) gebildet wird.

11. Verfahren nach Anspruch 9 oder 10, **dadurch gekennzeichnet, dass** für den Prüfwert (24) zusätzlich eine Wichtung der Bits des digitalen Messwerts (12) vorgenommen wird und/oder eine Kanalinformation (19) berücksichtigt wird.

12. Verfahren nach einem der Ansprüche, **dadurch gekennzeichnet, dass** mittels der Prozessoreinrichtung (22) im Falle einer Störung die Auswertung und/oder das Senden von Datentelegrammen (29) mindestens solange unterbunden wird, bis anhand eines weiteren Messwerts und des jeweiligen Prüfwerts des weiteren Messwerts keine Störung mehr erkannt wird.

13. Verfahren nach einem der Ansprüche 9 bis 12, **dadurch gekennzeichnet, dass** mittels der Prozessoreinrichtung (22) im Falle einer Störung die Auswertung und/oder das Senden von Datentelegrammen für mindestens solange unterbunden wird, bis mittels des integrierten Schaltkreises (14) für den elektronischen Speicherbaustein (15) mit der Konfiguration ein Konfigurationsprüfwert berechnet ist, um anschließend den berechneten Konfigurationsprüfwert mit einem vorher festgelegten Konfigurationsprüfwert zu vergleichen, um im Falle einer Abweichung von berechnetem Konfigurationsprüfwert und vorher festgelegten Konfigurationsprüfwert eine Störung zu bestätigen oder im Falle identischer Konfigurationsprüfwerte die Auswertung und/oder das Senden von Datentelegrammen (29) freizugeben.

14. Verfahren nach einem der Ansprüche 9 bis 13, **dadurch gekennzeichnet, dass** für den integrierten Schaltkreis (14) ein field-programmable gate-array und für den elektronischen Speicherbaustein (15) ein static random-access memory verwendet werden.

15. Verfahren nach einem der Ansprüche 9 bis 14, **dadurch gekennzeichnet, dass** für das Betriebsmittel (1) ein Schutzgerät verwendet wird und dass die Datentelegramme (29) Schutzbefehle (21) aufweisen, und dass das Schutzgerät mittels einer Datenkommunikationseinrichtung (20) Datentelegramme (29) an Schalter (4) als andere Betriebsmittel in einem Energienetz (2) sendet.
